Europäisches Patentamt

European Patent Office

Office européen des brevets

(11) Publication number: 0 392 676
A2

# EUROPEAN PATENT APPLICATION

(21) Application number: 90302965.0

(51) Int. Cl.5: H01L 31/04

(22) Date of filing: 20.03.90

(30) Priority: 14.04.89 JP 95027/89

(43) Date of publication of application:
17.10.90 Bulletin 90/42

(84) Designated Contracting States:
DE GB

(71) Applicant: Isuzu Motors Limited
6-22-10 Minamiooi Shinagawa-ku
Tokyo 140(JP)

(72) Inventor: Kurabayashi, Ken
1-1-202 Shimomachiya 3-chome
Chigasaski-shi, Kanagawa(JP)
Inventor: Tsuchiya, Yoshinobu
330-4 Shimotsuchidana
Fujisawa-shi, Kanagawa(JP)
Inventor: Shirata, Akihiro
3-11, Seya 6-chome, Seya-ku
Yokohama-shi, Kanagawa(JP)

(74) Representative: Brunner, Michael John et al
GILL JENNINGS & EVERY 53-64 Chancery
Lane
London WC2A 1HN(GB)

(54) Solar cell battery.

(57) A solar cell battery has a plurality of series-connected solar cells (1) to produce a desired output voltage. Each of the solar cells is connected parallel to a capacitor (2), and a diode (3) is connected to allow an electromotive force generated by the solar cell to flow in a forward direction. When some of the solar cells are shielded from solar radiation, the electric energy stored in the capacitors connected to these shielded solar cells is available as part of the output voltage, without being charged through the solar cells. Therefore, the output voltage of the entire battery is not lowered.

Fig. 1

EP 0 392 676 A2

The present invention relates to a solar cell battery having a plurality of connected solar cells for converting energy from the sun into electric energy.

With the advance of semiconductor-applied technology, solar cells which convert energy from the sun or artificial light directly into electrical energy are used in various applications in recent years.

The solar cells usually have a PN junction structure on a substrate of monocrystalline silicon. One solar cell generates an electromotive force of about 0.5 V in response to application of solar radiation.

Therefore, if an electric device which requires a voltage of few volts or more is to be powered by solar energy, a plurality of solar cells are connected in series to produce the desired voltage.

When the solar radiation applied to a solar cell is reduced or eliminated, the electromotive force generated by the solar cell is also lowered or eliminated, and the necessary electric power can no longer be supplied by the solar cell alone. As a solution to this problem, there has been proposed a power supply element in which the electrically conductive substrate of a solar cell doubles as an electrode of a chemical cell or a capacitor (see Japanese Laid-Open Patent Publication No. 61-(1986)-283173).

In the event that some of the series-connected solar cells used as an electric device power supply are not irradiated with solar radiation, those solar cells do not generate electric energy while the other irradiated solar cells generate electric energy. When this happens, the output electric power of the entire power supply largely drops, and the electric device connected as the load to the power supply does not function properly.

According to the power supply element proposed by the above publication, since the conductive substrate of the solar cell doubles as the chemical cell or capacitor electrode, the power supply element is small in size, but its cost is high because its manufacture requires dedicated materials and equipment.

In view of the foregoing shortcomings of the conventional solar cells, it an object of the present invention to provide a solar cell battery whose output power will not be adversely affected even if some of series-connected solar cells are not irradiated with solar radiation.

To achieve the above object, there is provided in accordance with the present invention a solar cell battery comprising a solar cell for converting energy of light into electric energy, a capacitor connected parallel to the solar cell, and a diode connected between the solar cell and the capacitor, for allowing an electromotive force generated by the solar cell to pass therethrough.

To obtain a desired high output voltage, a plurality of units each including the solar cell, the capacitor, and the diode are connected in series to each other through the terminals of the capacitors.

When some of the solar cells are shielded from solar radiation, the electric energy stored in the capacitors connected to these shielded solar cells is available as part of the output voltage, instead of electromotive forces from the shielded solar cells.

The diode serves to prevent the electric energy stored in the capacitor from being discharged through the solar cell.

Even if some or all of the solar cells are shielded from solar radiation, the output electric energy of the solar cell battery remains unchanged, and a load connected to the solar cell battery can continuously operate stably.

Since the solar cell and the capacitor are separate from each other without any common electrode used, and the reverse-blocking diode is connected between the solar cell and the capacitor, the solar cell battery can be manufactured without the need for dedicated materials and equipment, and hence is inexpensive to manufacture.

The above and other objects, features and advantages of the present invention will become more apparent from the following description when taken in conjunction with the accompanying drawings in which preferred embodi ments of the present invention are shown by way of illustrative example.

Fig. 1 is a circuit diagram of a solar cell battery according to the present invention;

Fig. 2 is a fragmentary cross-sectional view showing the structure of the solar cell battery; and

Fig. 3 is a circuit diagram of a solar cell battery unit which is composed of a plurality of solar cell wafers.

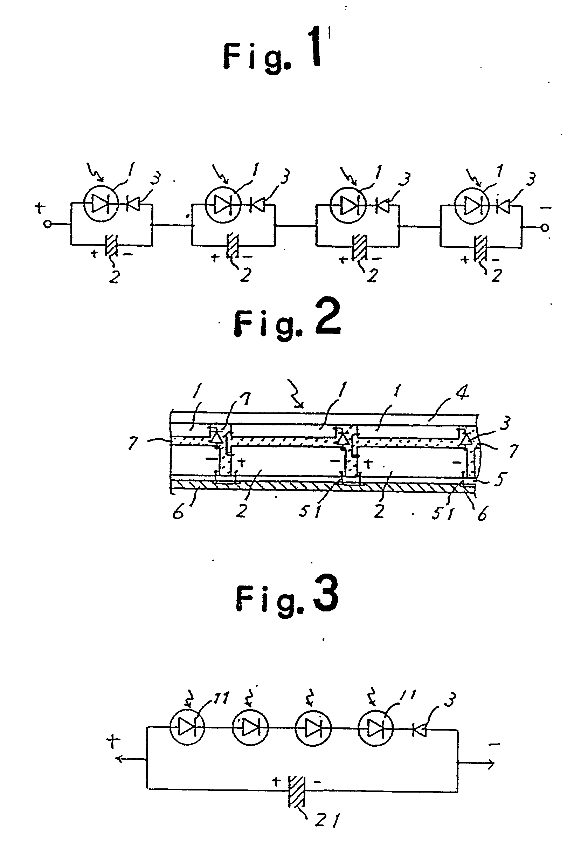

As shown in Figs. 1 and 2, a solar cell battery according to the present invention comprises a plurality of solar cells 1 connected in series with each other. Each of the solar cells 1 has a PN junction structure on a substrate of monocrystalline silicon. When light is applied to the solar cell 1, a positive electromotive force is generated from the P layer in the solar cell 1 due to the photovoltaic effect. One solar cell 1 can produce an open-circuit voltage of about 0.5 V when it is irradiated with solar radiation in fine weather, for example.

The solar cell battery also includes a plurality of large-capacitance capacitors 2 which comprise electric double layer capacitors that are used as a backup power supply for the memory of an electronic device. Each of the capacitors 2 is connected parallel to one solar cell 1 through a diode 3 which is connected as a unidirectional element in series to the solar cell 1, and stores the electromotive force generated by the solar cell 1.

The diode 3 serves to prevent the electric charges stored in the capacitor 1 from flowing back into the solar cell 1 when the solar cell battery is not in operation. The diode 3 typically comprises a Schottky diode which has a small voltage drop in the forward direction.

The solar cell 1, the capacitor 2, and the diode 3 which are connected as described above serves as one unit. A plurality of such units are connected in series such that the output voltage of the entire solar cell battery reaches a desired voltage, and the series-connected circuit arrangement is used as a power supply for a.certain load.

As shown in Fig. 2, the front faces of the solar cells 1 are covered with a transparent protective member 4 which may comprise a glass panel or a plastic panel. The capacitors 2 are mounted on a baseboard 5 through which there extend connector wires 51 that interconnects adjacent capacitors 2. A filler 7 in the form of an electric insulating material is filled between the solar cells 1 and between the solar cells 1 and the capacitors 2. The filler 7 serves to secure the solar cells 1 and the capacitors 2 in place and protect them from external shocks.

The filler 7 may be replaced with separators disposed between the solar cells 1 and the capacitors 2, and lead wires interconnecting the solar cells 1 and the capaci tors 2 and lead wires of the diodes 3 may extend through the separators.

The solar cell battery thus constructed operates as follows: When solar radiation is applied to each of the solar cells 1, they are brightened and generate electromotive forces which are supplied through the diodes 3 to store electric energy in the capacitors 2.

The voltage between the opposite terminals of the solar cell battery is equal to the sum of the voltages produced by the respective series-connected units of the solar cell battery. When a load is connected between the terminals of the solar cell battery, the load is supplied with the stored electric energy.

When some of the series-connected units are shielded from the solar radiation, the solar cells 1 of the shielded units are darkened and do not produce electromotive forces. These darkened solar cells 1 then operate as oridinary diodes which block passage of the electromotive forces from the other active solar cells 1.

Since the capacitors which store the electromotive forces generated when the associated solar cells are connected to the darkened solar cells, the voltages across these capacitors compensate for the failure of the darkened solar cells. Accordingly, any voltage drop between the terminals of the series-connected units of the entire solar cell battery is small, and does not adversely affect the load connected between the terminals. Therefore, the solar cell battery can continuously supply electric energy to the load.

Since the reverse-blocking diode 3 is connected to the capacitor 2 in each of the units, the electric energy stored in the capacitor 2 is not discharged through each of the darkened solar cells 1.

Fig. 3 shows another solar cell battery unit which comprises a plurality of solar cell wafers 11 that are connected in series to add electromotive forces generated thereby. The solar cell wafers 11 are connected in series to a reverse-blocking diode 3, and a capacitor 21 is connected parallel to the solar cell wafers 11 and the diode 3.

With a plurality of solar cell battery units shown in Fig. 3 being connected in series, the number of diodes used in the entire solar cell battery is reduced, and the electromotive forces generated by the solar cell wafers 11 can effectively be utilized since the voltage drops caused by the diodes in the forward direction are lowered.

Although certain preferred embodiments have been shown and described, it should be understood that many changes and modifications may be made therein without departing from the scope of the appended claims.

## Claims

1. A solar cell battery comprising:
a solar cell (1) for converting energy of light into electric energy;
a capacitor (2) connected parallel to the solar cell; and
a diode (3) connected between the solar cell and the capacitor, for allowing an electromotive force generated by the solar cell to pass therethrough.

2. A battery according to claim 1, wherein a plurality of units each including a solar cell, a capacitor, and a diode are connected in series to each other through the terminals of the capacitors.

3. A battery according to claim 1 or 2, wherein the capacitor comprises an electric double layer capacitor.

4. A battery according to any of claims 1 to 3, wherein the solar cell comprises a plurality of solar cell wafers.

5. A battery according to any of claims 1 to 4, wherein the diode comprises a Schottky diode.

# Fig. 1

# Fig. 2

# Fig. 3